# EUROPÄISCHE PATENTSCHRIFT

(11) **EP 1 684 429 B1**
(45) Veröffentlichungstag und Bekanntmachung des Hinweises auf die Patenterteilung: **29.04.2009**
(21) Anmeldenummer: 06100147.5
(22) Anmeldetag: 09.01.2006
(51) Int. Cl.: H03J 5/24

(54) **Schaltungsanordnung und Verfahren zur Frequenzbereichsumschaltung**
Circuit arrangement and method for band switching
Arrangement de circuit et procédé pour une commutation de bande

(30) Priorität: 14.01.2005 DE 102005001734
(43) Veröffentlichungstag der Anmeldung: 26.07.2006
(73) Patentinhaber: ROBERT BOSCH GMBH, 70442 Stuttgart (DE)
(72) Erfinder: Kottschlag, Gerhard, 31139, Hildesheim (DE)

(56) Entgegenhaltungen:
- EP-A- 1 110 317
- EP-A- 1 381 157
- US-A- 6 064 866
- US-A1- 2001 005 673
- US-A1- 2003 100 272
- PATENT ABSTRACTS OF JAPAN Bd. 011, Nr. 314 (E-549), 13. Oktober 1987 (1987-10-13) & JP 62 107529 A (HITACHI LTD), 18. Mai 1987 (1987-05-18)

## Beschreibung

### Technisches Gebiet

Die Erfindung betrifft eine elektronische Schaltungsanordnung gemäß dem Oberbegriff des Anspruchs 1, sowie ein dazugehöriges Verfahren gemäß dem Oberbegriff des Anspruchs 10.

### Stand der Technik

Aus dem Stand der Technik sind elektronische Schaltungen bekannt, welche in verschiedenen durchstimmbaren Frequenzbereichen schwingende Resonanzkreise aufweisen, wobei die Resonanzfrequenz durch ein Abstimmsignal einstellbar ist. Solche Schaltungen kommen zum Beispiel in Rundfunkempfangsgeräten zum Einsatz, in denen verschiedene Empfangsbereiche ausgewählt werden können, je nachdem, in welchem Land die Radiosignale empfangen werden sollen. So liegen die verwendeten Frequenzbänder für den UKW-Empfang in Europa zwischen 87,5 und 108 MHz, in Japan dagegen zwischen 76 und 90 MHz. Soll ein Rundfunkempfangsgerät für die beiden Frequenzbänder eingesetzt werden, so kann eine Umschaltungsvorrichtung vorgesehen werden, welche gegenüber Anordnungen, welche für den gesamten Abstimmbereich ausgelegt sind, gewisse Vorteile aufweist.

Rundfunkempfangsgeräte arbeiten üblicherweise nach dem Superheterodyn-Prinzip. Dabei wird das zu empfangende Antennensignal in einer Hochfrequenzverstärkerstufe, welche auf die Trägerfrequenz des Signals abgestimmt wird, vorverstärkt. Gleichzeitig wird ein Schwingkreis auf einer Oszillatorfrequenz betrieben, welche sich von dem Trägersignal durch die so genannte Zwischenfrequenz unterscheidet. In einem Mischer werden sodann das Eingangssignal und das auf der Oszillatorfrequenz schwingende Referenzsignal derart überlagert, dass ein Signal auf der Zwischenfrequenz entsteht. Dies hat den Vorteil, dass Signalverstärkung und Demodulation unabhängig von der Empfangsfrequenz auf einer konstanten Frequenz stattfinden kann. Ein üblicher Wert für die Zwischenfrequenz ist zum Beispiel 10,7 MHz für den UKW-Rundfunk. Es ist dabei vorteilhaft, den Hochfrequenzverstärker und den Referenzschwingkreis durch das gleiche Abstimmsignal anzusteuern. Zur Abstimmung der dazugehörigen Resonanzfrequenzen werden üblicherweise Kapazitätsdioden benutzt. Dabei wird eine Abstimmspannung in eine definierte Kapazität in den jeweiligen elektromagnetischen Schwingkreisen übersetzt. Allerdings darf die Abstimmspannung nicht zu niedrig gewählt werden, da im Spannungsbereich zwischen 0 V und einer bestimmten Minimalspannung die Kapazitätsdioden aufgrund der überlagerten Hochfrequenzsignale zeitweise in den leitenden Zustand gelangen und somit nicht mehr als Kondensator genutzt werden können.

Die US 2003/0100272 A1 offenbart einen sich selbst abstimmenden Bandpassfilter in einem Mikrowellensignalgeber und/oder -empfänger. Der Bandpassfilter umfasst zwei separate Filtereinrichtungen, deren Durchlassbänder jeweils unterschiedlichen Frequenzbereichen entsprechen. Ferner sind Kontrollmittel vorhanden, mittels denen zwischen den beiden Filtereinrichtungen hin und her geschaltet werden kann.

Die JP 62107529 A offenbart eine Abstimmvorrichtung. Zur Auswahl eines Frequenzbandes von in Reihe geschalteten Bandpassfiltern ist eine Anordnung bestehend aus einer Abstimmeinrichtung, einem VCO und einem Frequenzteiler vorgesehen.

Ein Rundfunkempfangsgerät, welches als Überlagerungsempfänger arbeitet und welches zwischen verschiedenen Frequenzbändern umschaltbar ist, ist in der EP 1 101 317 offenbart. In dem dort beschriebenen Rundfunkempfangsgerät sind zwei separat wirksam schaltbare, durchstimmbare Abstimmstufen für zwei Empfangsbereiche an eine Empfangsantenne angeschlossen, wobei mit einem Umschalter eine der Abstimmstufen ausgewählt werden kann. Gleichzeitig kann mit einem zweiten, simultan betätigten Umschalter eine Umschaltung der Frequenz bereiche in einem Mischoszillator erzielt werden, welcher auf einer Frequenz schwingt, welche sich von dem Empfangssignal durch die Zwischenfrequenz unterscheidet. Die Umschaltung des Mischoszillators geschieht dadurch, dass die Oszillatorspule eine Anzapfung aufweist, durch die wahlweise die ganze Spule oder nur ein Teil der Spule zum elektromagnetischen Schwingkreis des Mischoszillators beiträgt. Nachteilig ist bei der genannten elektronischen Vorrichtung, dass zusätzliche Bauteile für die Schaltfunktion und die Übertragung des benötigten Schaltsignals erforderlich sind.

### Darstellung der Erfindung, Aufgabe, Lösung, Vorteile

Aufgabe der Erfindung ist es, eine Vorrichtung anzugeben, welche eine Einsparung des Bauteilaufwandes ermöglicht.

Erfindungsgemäß wird diese Aufgabe mittels einer elektronischen Schaltungsanordnung mit den in Anspruch 1 genannten Merkmalen oder mittels eines Verfahrens mit den in Anspruch 9 genannten Merkmalen gelöst.

Dadurch, dass das Abstimmsignal das Umschaltsignal trägt und die elektronische Schaltungsanordnung Mittel zur Auswertung des im Abstimmsignal vorhandenen Umschaltsignals sowie Mittel zur Speicherung des gewählten Schaltzustands aufweist, ist es vorteilhaft möglich, über das Abstimmsignal eine zweite Information zu übertragen, wobei diese zusätzliche Information die Umschaltung ganz verschiedener Zustände, wie z.B. der Verstärkung oder anderer Funktionen, bewirken kann. Im Fall, dass es sich bei den umschaltbaren Zuständen um mindestens zwei Frequenzbereiche handelt, ermöglicht es die erfindungsgemäße Lösung, sowohl Umschaltung als auch Abstimmung verschiedener Resonanzschwingkreise über dieselbe elektrische Leitung erfolgen zu lassen. Die Integrierung der relevanten Bauelemente in Modulen wird dadurch nahe gelegt.

Ferner ist es gemäß der Erfindung vorgesehen, dass eine erste Abstimmspannung eines spannungsgesteuerten Oszillators einer PLL von einem programmierbaren Verstärker in eine zweite Abstimmspannung für die Abstimmung eines Verstärkerfilters transformiert wird und zur Umschaltung ein Offset und/oder Gain des programmierbaren Verstärkers auf einen vorgebbaren Wert eingestellt wird.

In bevorzugter Ausgestaltung der Erfindung ist vorgesehen, dass ein elektromagnetischer Schwingkreis mindestens zwei Frequenzbereiche dadurch abdeckt, dass er mit mindestens einer mit einer Anzapfung versehenen Spule ausgestattet und durch eine Wirksamschaltung oder Unwirksamschaltung der Anzapfung umschaltbar ist. Alternativ dazu ist es möglich, dass mindestens zwei Frequenzbereiche durch parallel geschaltete und umschaltbare elektromagnetische Schwingkreise abgedeckt werden.

Eine sehr einfache Realisierung der Abstimmung des gewählten Frequenzbereiches erreicht man durch den Einsatz von Kapazitätsdioden, deren Kapazität durch eine Abstimmspannung variiert werden kann.

Insbesondere ist bevorzugt, dass die Mittel zur Auswertung des im Abstimmsignal vorhandenen Umschaltsignals einen Vergleicher umfassen, welcher den logischen Zustand wechselt, wenn das Abstimmsignal unter eine vorgebbare Signalschwelle sinkt. Auf diese Weise kann man eine Umschaltung des Frequenzbereiches oder allgemeiner des Schaltungszustandes einfach dadurch bewirken, dass man misst, wie lange das Abstimmsignal unter der Signalschwelle verbleibt und in Abhängigkeit der Zeitdauer den passenden Frequenzbereich oder Schaltungszustand anwählt.

Mit der erfindungsgemäßen Schaltanordnung wird ein Verfahren ausgerührt, welches sich dadurch auszeichnet, dass das Abstimmsignal das Umschaltsignal trägt und dass ein bestimmter Schaltzustand durch die Auswertung des Abstimmsignals ausgewählt wird.

Ferner ist vorgesehen, dass eine Umschaltung des Schaltzustands erfolgt, wenn das Abstimmsignal unter einen Schwellenwert absinkt oder über einen Schwellenwert steigt, und/oder dass eine Umschaltung in einen vorgebbaren Schaltzustand erfolgt, wenn das Abstimmsignal während eines dem Schaltzustand zugeordneten Zeitintervalls unter einen Schwellenwert absinkt oder über einen Schwellenwert steigt.

Durch die erfindungsgemäß vorgesehene Möglichkeit, dass die Umschaltung zwischen mindestens zwei Frequenzbereichen erfolgt, wird es ermöglichst, sowohl Umschaltung als auch Abstimmung verschiedener Resonanzschwingkreise über dieselbe elektrische Leitung durchzuführen.

Gemäß einer weiteren vorteilhaften Weiterbildung kann vorgesehen werden, dass zur Umschaltung eine PLL auf eine Frequenz innerhalb eines vorgebbaren Frequenzbereichs eingestellt wird, und/oder dass zur Umschaltung in einer PLL ein Teilerwert eingestellt wird, bei welcher die PLL ausrastet.

Weitere bevorzugte Ausgestaltungen der Erfindung ergeben sich aus den übrigen, in den Unteransprüchen genannten Merkmalen.

### Kurze Beschreibung der Zeichnungen

Die Erfindung wird nachfolgend in Ausführungsbeispielen anhand der zugehörigen Zeichnungen näher erläutert. Es zeigen:
Figur 1 einen Ausschnitt aus einem möglichen Verlauf einer Abstimmspannung über die Zeit,
Figur 2 ein schematisiertes Blockschaltbild der erfindungsgemäßen elektronischen Vorrichtung, und
Figur 3 ein Blockschaltbild der erfindungsgemäßen elektronischen Vorrichtung mit einer PLL (phase locked loop) zur Rückkopplung mit einem Oszillator.

### Bester Weg zur Ausführung der Erfindung

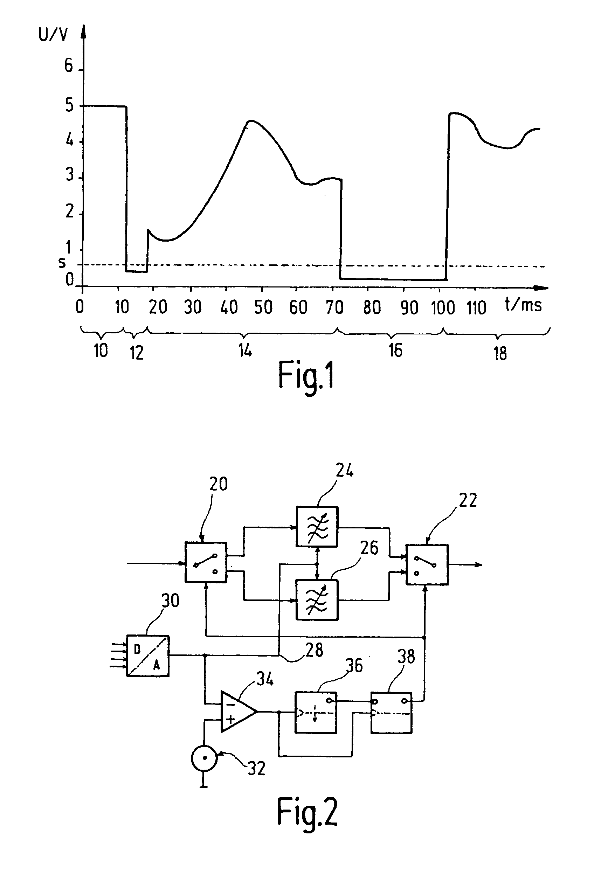

Figur 1 zeigt einen Ausschnitt aus einem möglichen Verlauf einer Abstimmspannung über die Zeit. Nach einem Initialisierungsintervall 10, in welchem die Abstimmspannung auf einen hohen Pegel eingestellt wird, erfolgt ein Schaltimpuls 12 (Länge τ₁), durch welchen einer von zwei Frequenzbereichen ausgewählt wird. In dem darauffolgenden Zeitintervall 14 durchläuft die Abstimmspannung verschiedene Werte oberhalb der Schaltschwelle s. Ein Schaltimpuls 16 mit einer zweiten defi-nierten Länge (τ₂), welche größer ist als die des Schaltimpulses 12, schaltet nun den Frequenzbereich um (im vorliegenden Beispiel beträgt τ1 = 10 ms und τ₂= 20 ms). Im Zeitintervall 18 durchläuft die Abstimmspannung wiederum einen bestimmten Wertebereich, wobei die Spannungswerte verschiedenen Frequenzen in dem zweiten Frequenzbereich entsprechen. Beide Schaltimpulse 12 und 16 weisen bestimmte, vorher eingestellte Zeitwerte auf, welche durch eine Schaltung, wie in Figur 2 schematisiert dargestellt, ausgewertet werden können. Durch zwei Umschalter 20, 22 wird jeweils einer von zwei abstimmbaren Filtern, welche in zwei verschiedenen, möglicherweise überlappenden Frequenzbereichen schwingen, angewählt. Der jeweils angewählte Schwingkreis 24, 26 wird durch das Abstimmsignal 28 auf einer bestimmten Frequenz zum Schwingen gebracht. Das Abstimmsignal 28 stammt hier von einem D/A-Wandler 30, welcher eine analoge Abstimmspannung erzeugt, die sowohl zur Einstellung der Filter 24 und 26 dient, als auch von der logischen, aus den Elementen 34, 36 und 38 bestehenden Einheit ausgewertet wird. Dabei schaltet der Vergleicher 34 auf den logischen Wert 1, sobald das Abstimmsignal 28 unter den Schwellenwert s fällt. Da-durch wird ein Mono-Flop 36 aktiviert, dessen charakteristischer Zeitwert zwischen den vordefinierten Zeitintervallen τ₁ und τ₂ liegt. Nachdem die Abstimmspannung 28 nach einem τ₁ oder τ₂ entsprechenden Zeitintervall wieder über den Schwellenwert s ansteigt, fällt der Ausgang des Vergleichers 34 wieder zurück auf den logischen Wert 0. Durch die fallende Flanke wird ein flankengesteuerter Flip-Flop getriggert, welcher den am Ausgang Q des Mono-Flops 36 liegenden logischen Zustand übernimmt. Je nachdem, ob zwischen dem Triggern des Mono-Flops 36 und dem Triggern des Flip-Flops 38 die Zeit τ₁ oder τ₂ verstrichen ist, speichert der Flip-Flop 38 eine logische 1 oder eine logische 0. Dementsprechend werden gleichzeitig die Schalter 20 und 22 in den entsprechenden Zustand gebracht.

In Analogie zu dem in Figur 1 dargestellten Verlauf der Abstimmspannung können die erfindungsgemäße Schaltungsanordnung und das dazugehörige Verfahren auch dadurch gekennzeichnet sein, dass das Abstimmsignal während der charakteristischen Zeitintervalle über einen Schwellenwert steigt. Dafür müssen nur geringfügige, nahe liegende Modifikationen der hier beschriebenen Schaltungen vorgenommen werden.

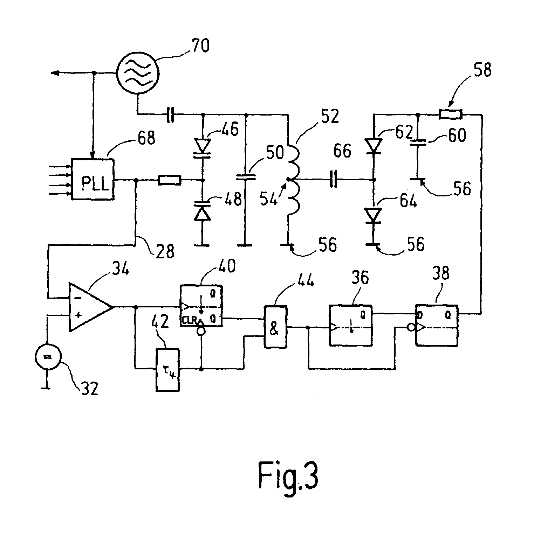

Ein zweites Ausführungsbeispiel ist in Figur 3 gezeigt. Dabei sind auch hier die Bauelemente 32, 34, 36 und 38 vorgesehen, welche wie anhand der Figur 2 erläutert einen Vergleich der Abstimmspannung 28 mit einer Referenzspannung 32 durchführen und in Abhängigkeit der Länge des Umschaltsignals für eine Änderung des Frequenzbereiches sorgen. Dazwischen geschaltet sind die Bauelemente 40, 42 und 44, welche Impulse unterhalb der Schaltschwelle s unterdrücken, wenn sie kürzer als eine Zeitkonstante τ₃ eines zweiten Mono-Flops 40 sind. Diese können in dem hier aufgeführten Ausführungsbeispiel dadurch entstehen, dass die Abstimmspannung nicht von einem D/A-Wandler, sondern direkt von einer PLL stammt. Der logische Wert 1 wird am Ausgang eines UND-Gatters 44 nur dann erzeugt, wenn am Ausgang des Vergleichers 34 der logische Wert 1 für ein Zeitintervall > τ₃ anliegt. Die Verzögerungsstufe 42 mit der Zeitkonstante τ₄ dient dazu, Signallaufzeiten im Mono-Flop auszugleichen, so dass das UND-Gatter bereits sperrt, wenn die steigende Flanke des Vergleicherausgangssignals am UND-Gatter eintrifft (im vorliegenden Beispiel beträgt τ₃ = 2 ms und τ₄ = 100 µs).

In der in Figur 3 gezeigten Schaltung besteht ein Schwingkreis aus zwei Kapazitätsdioden 46 und 48, einer Festkapazität 50 und einer Spule 52. Die Kapazität der Kapazitätsdioden 46 und 48 sind durch ein Abstimmsignal 28 einstellbar. Andererseits schwingt der Schwingkreis in verschiedenen Frequenzbereichen, je nachdem, auf welchem Potential sich die Anzapfung 54 befindet. Wenn am Ausgang des Flip-Flops 38 der logische Wert 1 anliegt, fließt über den Widerstand 58 und über die Schaltdioden 62 und 64 ein Strom zum Bezugspotential 56. Dadurch, dass die Dioden 62 und 64 niederohmig werden und die Impedanzen der Kondensatoren 60 und 66 im Hochfrequenzbereich vernachlässigbar sind, ist für den Schwingkreis effektiv nur die obere Wicklung der Spule 52 wirksam. Umgekehrt wird bei einem logischen Wert 0 am Ausgang des Flip-Flops 38 die volle Spulenwicklung 54 in die Schwingung einbezogen, was einem tieferen Frequenzbereich entspricht.

Quelle der Abstimmspannung 28 ist eine PLL-Baugruppe 68, welche in bekannter Weise die Schwingung eines Oszillators 70 in Beziehung zu einer Referenzfrequenz setzt und eine Korrekturspannung erzeugt, welche den Kapazitätsdioden 46 und 48 sowie dem Vergleicher 34 zugeführt wird. Um nun Umschaltsignale (vergleiche Signale 12 und 16 in Figur 1) in der PLL zu erzeugen, muss die Abstimmspannung 28 für die Zeitdauer τ₁ oder τ₂ unter den Schwellenwert s gebracht werden. Hierzu lässt man die PLL während einer Zeitdauer τ₁ oder τ₂ auf einer Referenzfrequenz schwingen, welche eine Abstimmspannung 28 unterhalb des Schwellenwertes s erzeugt. Bei jedem regulären Frequenzwechsel innerhalb eines Abstimmbereichs rastet die PLL kurzzeitig aus und erzeugt ein unkontrolliertes Abstimmsignal 28, das auch kurzzeitig unter den Schwellenwert s absinken kann, obwohl mit diesem Frequenzwechsel keine Bereichsumschaltung initiiert werden soll. Die oben beschriebene Verzögerungsschaltung, welche aus den Bauelementen 40, 42 und 44 besteht, sorgt dafür, dass Signale, welche durch das kurzfristige unkontrollierte Schwanken der Abstimmspannung entstehen, nicht für die Auswahl des Frequenzbereichs ausgewertet werden.

In einem nicht näher dargestellten Ausführungsbeispiel der erfindungsgemäßen elektronischen Schaltung wird die PLL während eines Zeitintervalls τ₁ oder τ₂ gezielt in einen unkontrollierten Zustand gebracht, indem die PLL auf eine Frequenz eingestellt wird, die zu keiner stabilen Abstimmspannung führt, da sie weit außerhalb des zulässigen Abstimmbereichs des Oszillators 70 liegt. In diesem Fall kann eine Auswerteschaltung vorgesehen sein, welche die Zeitdauer auswertet, während der die PLL ausgerastet ist. Der in Figur 3 dargestellte Vergleicher 34 würde dabei entfallen.

In einem weiteren, nicht weiter dargestellten Ausführungsbeispiel wird die Abstimmspannung des spannungsgesteuerten Oszillators einer PLL über einen zusätzlichen programmierbaren Verstärker geführt und von diesem in eine zweite Abstimmspannung für die Abstimmung eines Verstärkerfilters transformiert. Nun ist es möglich, den Offset und/oder Gain des Verstärkers auf einen vorgebbaren Wert umzuprogrammieren und auf diese Weise ein Umschaltsignal zu erzeugen.

In einem weiteren, nicht weiter dargestellten Ausführungsbeispiel wird eine Umschaltung des Frequenzbereiches vorgesehen, sobald die Abstimmspannung 28 unter den definierten Schwellenwert s fällt. Dabei wird die Zeitdauer des Umschaltsignals nicht ausgewertet. Der Mono-Flop 36 ist bei einem solchen Vorgehen überflüssig. Allerdings ist die Einstellung des aktuellen Frequenzbereiches jetzt nicht mehr einfach ablesbar und muss z. B. durch eine Auswertung des Flip-Flop-Ausgangs verifiziert werden.

## Patentansprüche

1. Elektronische Schaltungsanordnung, in welcher eine Frequenzabstimmung durch ein Abstimmsignal (28) erfolgt und welche Mittel zur Umschaltung zwischen mindestens zwei Schaltzuständen durch ein Umschaltsignal, insbesondere in einem Rundfunkempfangsgerät, umfasst, wobei das Abstimmsignal das Umschaltsignal trägt und die elektronische Schaltungsanordnung Mittel zur Auswertung des im Abstimmsignal vorhandenen Umschaltsignals (34, 36, 38) aufweist, und wobei die Schaltungsanordnung Mittel zur Speicherung des gewählten Schaltzustands (38) aufweist,
eine erste Abstimmspannung eines spannungsgesteuerten Oszillators einer PLL von einem programmierbaren Verstärker in eine zweite Abstimmspannung für die Abstimmung eines Verstärkerfilters transformiert wird und zur Umschaltung ein Offset und/oder Gain des programmierbaren Verstärkers auf einen vorgebbaren Wert einstellbar ist.

2. Elektronische Schaltungsanordnung nach Anspruch 1,
**dadurch gekennzeichnet, dass**
die Umschaltung zwischen mindestens zwei Frequenzbereichen erfolgt.

3. Elektronische Schaltungsanordnung nach Anspruch 2,
**dadurch gekennzeichnet, dass**
ein elektromagnetischer Schwingkreis mindestens zwei der Frequenzbereiche dadurch abdeckt, dass er mit mindestens einer mit einer Anzapfung (54) versehenen Spule (52) ausgestattet und durch eine Wirksamschaltung oder Unwirksamschaltung der Anzapfung (54) umschaltbar ist.

4. Elektronische Schaltungsanordnung nach Anspruch 2,
**dadurch gekennzeichnet, dass**
mindestens zwei der Frequenzbereiche durch parallel geschaltete und umschaltbare elektromagnetische Schwingkreise (24, 26) abgedeckt werden.

5. Elektronische Schaltungsanordnung nach Anspruch 3 oder 4,
**dadurch gekennzeichnet, dass**
mindestens ein elektromagnetischer Schwingkreis durch das Abstimmsignal abstimmbare Kapazitätsdioden (46, 48) umfasst.

6. Elektronische Schaltungsanordnung nach einem der vorangehenden Ansprüche,
**dadurch gekennzeichnet, dass**
die Mittel zur Auswertung des im Abstimmsignal vorhandenen Umschaltsignals einen Vergleicher (34) umfassen, welcher den logischen Zustand wechselt, wenn das Abstimmsignal (28) unter eine vorgebbare Signalschwelle sinkt oder über eine vorgebbare Signalschwelle steigt.

7. Elektronische Schaltungsanordnung nach einem der vorangehenden Ansprüche,
**dadurch gekennzeichnet, dass**
zur Umschaltung eine PLL (68) auf eine Frequenz innerhalb eines vorgebbaren Frequenzbereichs einstellbar ist.

8. Elektronische Schaltungsanordnung nach einem der vorangehenden Ansprüche,
**dadurch gekennzeichnet, dass**
zur Umschaltung in einer PLL (68) ein Teilerwert einstellbar ist, bei welcher die PLL (68) ausrastet.

9. Verfahren zur Umschaltung zwischen mindestens zwei Schaltzuständen durch ein Umschaltsignal, bei welchem eine Frequenzabstimmung durch ein Abstimmsignal (28) erfolgt, insbesondere in einem Rundfunkempfangsgerät, wobei das Abstimmsignal (28) das Umschaltsignal trägt und der Schaltzustand durch die Auswertung des Abstimmsignals (28) ausgewählt wird,
**dadurch gekennzeichnet, dass** eine Umschaltung in einen vorgebbaren Schaltzustand erfolgt, wenn das Abstimmsignal (28) während eines dem Schaltzustand zugeordneten Zeitintervalls unter einen Schwellenwert s absinkt oder über einen Schwellenwert s steigt.

10. Verfahren nach Anspruch 9,
**dadurch gekennzeichnet, dass**
die Umschaltung zwischen mindestens zwei Frequenzbereichen erfolgt.

11. Verfahren nach einem der Ansprüche 10-13,
**dadurch gekennzeichnet, dass**
zur Umschaltung eine PLL (68) auf eine Frequenz innerhalb eines vorgebbaren Frequenzbereichs eingestellt wird.

12. Verfahren nach einem der Ansprüche 9-11,
**dadurch gekennzeichnet, dass**
zur Umschaltung in einer PLL (68) ein Teilerwert eingestellt wird, bei welcher die PLL (68) ausrastet.

13. Verfahren nach einem der Ansprüche 9-12,
**dadurch gekennzeichnet, dass**
eine erste Abstimmspannung eines spannungsgesteuerten Oszillators einer PLL von einem programmierbaren Verstärker in eine zweite Abstimmspannung für die Abstimmung eines Verstärkerfilters transformiert wird und zur Umschaltung ein Offset und/oder Gain des programmierbaren Verstärkers auf einen vorgebbaren Wert eingestellt wird.

## Claims

1. Electronic circuit arrangement in which frequency tuning by a tuning signal (28) takes place and which comprises means for a changeover signal to change over between at least two switching states, particularly in a broadcast radio receiver, wherein the tuning signal carries the changeover signal and the electronic circuit arrangement has means for evaluating the changeover signal (34, 36, 38) which is present in the tuning signal, and wherein the circuit arrangement has means for storing the chosen switching state (38),
**characterized in that**
a first tuning voltage from a voltage-controlled oscillator in a PLL is transformed by a programmable amplifier into a second tuning voltage for tuning an amplifier filter, and an offset and/or gain of the programmable amplifier can be set to a predescribable value for the purpose of changeover.

2. Electronic circuit arrangement according to Claim 1,
**characterized in that**
the changeover is effected between at least two frequency ranges.

3. Electronic circuit arrangement according to Claim 2,
**characterized in that**
an electromagnetic resonant circuit covers at least two of the frequency ranges by virtue of it being equipped with at least one coil (52) provided with a tap (54) and being able to be changed over by virtue of activation or deactivation of the tap (54).

4. Electronic circuit arrangement according to Claim 2,
**characterized in that**
at least two of the frequency ranges are covered by parallel-connected electromagnetic resonant circuits (24, 26) which are capable of changeover.

5. Electronic circuit arrangement according to Claim 3 or 4,
**characterized in that**
at least one electromagnetic resonant circuit comprises capacitance diodes (46, 48) which can be tuned by the tuning signal.

6. Electronic circuit arrangement according to one of the preceding claims,
**characterized in that**
the means for evaluating the changeover signal which is present in the tuning signal comprise a comparator (34) which changes the logic state when the tuning signal (28) falls below a prescribable signal threshold or rises above a prescribable signal threshold.

7. Electronic circuit arrangement according to one of the preceding claims,
**characterized in that**
for the purpose of changeover a PLL (68) can be set to a frequency within a prescribable frequency range.

8. Electronic circuit arrangement according to one of the preceding claims,
**characterized in that**
for the purpose of changeover in a PLL (68) a divider value at which the PLL (68) unlatches can be set.

9. Method for a changeover signal to change over between at least two switching states, in which frequency tuning by a tuning signal (28) takes place, particularly in a broadcast radio receiver, wherein the tuning signal (28) carries the changeover signal and the switching state is selected by evaluating the tuning signal (28),
**characterized in that**
changeover to a prescribable switching state takes place when the tuning signal (28) falls below a threshold value s or rises above a threshold value s during a time interval associated with the switching state.

10. Method according to Claim 9,
**characterized in that**
the changeover takes place between at least two frequency ranges.

11. Method according to one of Claims 10-13,
**characterized in that**
for the purpose of changeover a PLL (68) is set to a frequency within a prescribable frequency range.

12. Method according to one of Claims 9-11,
**characterized in that**
for the purpose of changeover in a PLL (68) a divider value at which the PLL (68) unlatches is set.

13. Method according to one of Claim 9-12,
**characterized in that**
a first tuning voltage from a voltage-controlled oscillator in a PLL is transformed by a programmable amplifier into a second tuning voltage for tuning an amplifier filter, and for the purpose of changeover an offset and/or gain of the programmable amplifier is set to a prescribable value.

## Revendications

1. Arrangement de circuit électronique dans lequel un accord de fréquence est effectué par un signal d'accord (28) et qui comprend des moyens pour permuter entre au moins deux états de commutation à l'aide d'un signal de permutation, notamment dans un récepteur de radiodiffusion, le signal d'accord portant le signal de permutation et l'arrangement de circuit électronique présentant des moyens pour interpréter le signal de permutation (34, 36, 38) présent dans le signal d'accord, et l'arrangement de circuit présentant des moyens pour mémoriser l'état de commutation (38) sélectionné, **caractérisé en ce qu'**une première tension d'accord d'un oscillateur commandé en tension d'une PLL est transformée par un amplificateur programmable en une deuxième tension d'accord pour l'accord d'un filtre d'amplificateur et peut être réglée à une valeur pouvant être prédéfinie en vue de la permutation d'un offset et/ou d'un gain de l'amplificateur programmable.

2. Arrangement de circuit électronique selon la revendication 1, **caractérisé en ce que** la permutation s'effectue entre au moins deux plages de fréquences.

3. Arrangement de circuit électronique selon la revendication 2, **caractérisé en ce qu'**un circuit oscillant électromagnétique couvre au moins deux des plages de fréquences, **en ce qu'**il est équipé d'au moins une bobine (52) munie d'une prise de prélèvement (54) et **en ce que** la prise de prélèvement (54) peut être permutée par une commutation d'activation ou une commutation de désactivation.

4. Arrangement de circuit électronique selon la revendication 2, **caractérisé en ce qu'**au moins deux des plages de fréquences sont couvertes par des circuits oscillants (24, 26) électromagnétiques branchés en parallèle et permutables.

5. Arrangement de circuit électronique selon la revendication 3 ou 4, **caractérisé en ce qu'**au moins un circuit oscillant électromagnétique comprend des diodes à capacité variable (46, 48) pouvant être accordées par le signal d'accord.

6. Arrangement de circuit électronique selon l'une des revendications précédentes, **caractérisé en ce que** les moyens d'interprétation du signal de permutation présent dans le signal d'accord comprennent un comparateur (34) qui change d'état logique lorsque le signal d'accord (28) chute au-dessous d'un seuil de signal pouvant être prédéfini ou croît au-dessus d'un seuil de signal pouvant être prédéfini.

7. Arrangement de circuit électronique selon l'une des revendications précédentes, **caractérisé en ce que** pour la permutation, une PLL (68) peut être réglée sur une fréquence au sein d'une plage de fréquences pouvant être prédéfinie.

8. Arrangement de circuit électronique selon l'une des revendications précédentes, **caractérisé en ce que** pour la permutation, une PLL (68) peut être réglée sur une valeur de diviseur à laquelle la PLL (68) se déclenche.

9. Procédé de permutation entre au moins deux états de commutation à l'aide d'un signal de permutation, avec lequel un accord de fréquence est effectué par un signal d'accord (28), notamment dans un récepteur de radiodiffusion, le signal d'accord (28) portant le signal de permutation et l'état de permutation étant sélectionné par une interprétation du signal d'accord, **caractérisé en ce qu'**il se produit une permutation dans un état de commutation pouvant être prédéfini lorsque le signal d'accord (28), pendant un intervalle de temps affecté à l'état de commutation, chute au-dessous d'une valeur de seuil ou croît au-dessus d'une valeur de seuil.

10. Procédé selon la revendication 9, **caractérisé en ce que** la permutation s'effectue entre au moins deux plages de fréquences.

11. Procédé selon l'une des revendications 10 à 13, **caractérisé en ce que** pour la permutation, une PLL (68) est réglée sur une fréquence au sein d'une plage de fréquences pouvant être prédéfinie.

12. Procédé selon l'une des revendications 9 à 11, **caractérisé en ce que** pour la permutation, une PLL (68) est réglée sur une valeur de diviseur à laquelle la PLL (68) se déclenche.

13. Procédé selon l'une des revendications 9 à 12, **caractérisé en ce qu'**une première tension d'accord d'un oscillateur commandé en tension d'une PLL est transformée par un amplificateur programmable en une deuxième tension d'accord pour l'accord d'un filtre d'amplificateur et est réglée à une valeur pouvant être prédéfinie en vue de la permutation d'un offset et/ou d'un gain de l'amplificateur programmable.
